# EUROPEAN PATENT SPECIFICATION

(11) **EP 2 161 350 B1**
(45) Date of publication and mention of the grant of the patent: **12.09.2012**
(21) Application number: 08155403.2
(22) Date of filing: 29.04.2008
(51) Int. Cl.: C23C 14/08, C23C 14/56

(54) **Method for depositing of barrier layers on a plastic substrate as well as coating device therefor and a layer system**
Verfahren zum Abscheiden von Barriereschichten auf einem Kunststoffsubstrat, Beschichtungsvorrichtung dafür und Schichtensystem
Procédé de dépôt de couches protectrices sur un substrat plastique ainsi que dispositif de revêtement correspondant et système de couche

(30) Priority: 04.04.2008 EP 08103386
(43) Date of publication of application: 10.03.2010
(73) Proprietor: Applied Materials, Inc., Santa Clara, CA 95054 (US); Biofilm S.A., CP89608 (MX)
(72) Inventor: Hoffmann, Gerd, 63486, Bruchköbel (DE); Quiceno, Alexandra L., Cartagena (CO)
(74) Representative: Lang, Christian

(56) References cited:
- DE-A1- 19 935 181
- JP-A- 2006 044 130
- US-A1- 2003 228 475
- US-A1- 2008 008 893

## Description

### BACKGROUND OF THE INVENTION

### FIELD OF THE INVENTION

The present invention refers to a method for depositing of barrier layers on a plastic substrate comprising a first coating step for depositing a first barrier layer comprising a metal and a second coating step for depositing a second barrier layer comprising a resin and relates to a coating device for carrying out such a method as well as to a layer system produced by this method.

### PRIOR ART

Composite foils made from plastic substrates and barrier layers deposited thereon for preventing moisture and oxygen passing the composite foil are known in packaging industries for packing food, chemical goods, and pharmaceuticals as well as technical or other agricultural products. In order to protect the packed goods from moisture and oxygen which might cause environmental degradation of the products, different layer systems forming the composite foil are used. Examples are given in WO 02/02315 A1, DE 43 28 767 A1, DE 199 351 81 A1, DE 199 170 76 A1 or JP 2006044130 A. One commonly used layer system comprises a plastic foil as a substrate onto which a first barrier layer made of aluminium or aluminium oxide is deposited. On the first barrier layer a second barrier layer is provided for. The second barrier layer is made of a melamine resin. Both barrier layers may be deposited at the surface of the plastic foil by evaporation processes. However, although such a layer system comprises good protection for the goods packed by such a foil with respect to moisture and oxygen, pure adhesion of the melamine resin on the aluminium or alumina layer is a serious drawback.

US 2008/0008893 A1 discloses a method and a device for producing transparent conductive articles. The device for coating a plastic substrate comprises two flash evaporators for evaporating monomers with a magnetron sputter device between the two flash evaporators.

### DISCLOSURE OF THE INVENTION

### OBJECT OF THE INVENTION

Therefore, it is an object of the present invention to improve adhesion of melamine resin on an aluminium or alumina barrier layer on a plastic foil. Generally, it is an object of the present invention to provide a method as well as a coating device for coating of a plastic substrate with barrier layers which have a good adhesion as well as a good volume resistance against moisture and oxygen. Moreover, an appropriate layer system should be provided for. In addition, the coating device should be simple to use and to manufacture and the method should be easy to be carried out.

### TECHNICAL SOLUTION

The above-mentioned objects are solved by a coating device having the features of claim 1 as well as a method having the features of claim 8 as well as a layer system with the features of claim 17. Preferred embodiments are subject matter of the dependent claims.

The present invention is based on the finding that the adhesion of a second barrier layer comprising a resin on a first barrier layer comprising a metal can be significantly improved by arranging an adhesive layer between the first and the second barrier layer. The adhesive layer according to the present invention comprises only one or several atomic layers or isles of deposition material which is deposited by a sputter process. Thus, according to the present invention the expression adhesive layer comprises a very thin continuous layer as well as a non-continuous layer having only spread parts of a layer in form of separate isles.

The material used for depositing an adhesive layer can be chosen from silicon, silicon oxide, especially non-stoichiometric SiOₓ, iron, steel, stainless steel, chromium, nickel, vanadium as well as alloys and oxides thereof. The deposition of such materials in only one or several atomic layers as well as in discrete agglomerations in form of isles leads to a significant improvement in adhesion while the other properties and especially the barrier function are maintained. The expression several or a few atomic layers means that there are only 2 to 20, especially 5 to 50, particularly about 10 rows of atoms or molecules one upon the other. The amount of deposited material can be as less that not even a complete continuous layer is deposited, but only discrete material isles are present in the first and the second barrier layer.

Such thin adhesive layer can be deposited by continuously moving the substrate during the deposition process. Accordingly, the deposition rate and the transport velocity at which the substrate to be deposited is moved over the sputter source, the amount of deposited material can be adapted. However, stationary deposition during which the substrate is not moved is also possible.

The inventive method of depositing a thin adhesive layer between the first and second barrier layer can be applied to a rigid plastic material or a flexible plastic material. Preferably, the invention is used for flexible plastic foils which can be used in packaging industries. Accordingly, the substrate can be a flexible plastic foil in form of a rollable band which can be processes in a web coating device. Such a web coating device may comprise two winding rolls for unwinding and winding the uncoated plastic foil or the coated plastic foil, respectively. Along the transport path from the unwinding roll to the winding roll a first coating station for depositing the first barrier layer, the second coating station for depositing the second coating layer and a treatment station for sputter depositing the adhesive layer may be located.

For the dynamic coating processes as well as for the treatment process, during which the substrate is moved, the speed of the substrate may be set to be between 0,1 -20 m/s, especially 3 - 14 m/s and particularly 5 to 11 m/s. Due to this velocity of the substrate appropriate sputter conditions may be set to achieve the required deposition of a thin adhesive layer.

The first coating step may be an evaporation step during which a metal is evaporated and coated to the surface of the plastic material. The evaporation may be carried out by a thermal evaporation so that the first coating station for carrying out the first coating step may comprise thermal evaporation means. However, other evaporation means like electron beam evaporation means or means for combined processes like electron beam evaporation and hollow cathode arc activated deposition (HAD process) are conceivable. In addition, it is also possible to carry out a reactive evaporation, for example by providing gas supply means for supplying reactive gas to the evaporation process.

The second coating step for depositing a second barrier coating may also be carried out by evaporation. Accordingly, thermal evaporation means for evaporation of resins and especially melamine resins may be provided for the second coating station.

As mentioned before, the adhesive layer or partial adhesive layer is deposited in a treatment station by a sputter process. For this purpose, the treatment station may comprise sputter means having at least one cathode, e. .g a rotatable cathode, especially a planar cathode. The cathode may comprise a target to be sputtered in front of the cathode or the target is used as the cathode. The at least one cathode may be a magnetron cathode which allows an higher sputter yield due to improved atomisation of the target material caused by the magnetic field of the magnets of the magnetron so as to allow to perform the sputter process at a higher deposition rate.

Preferably, the sputter means may comprise a so-called "twin mag" arrangement in which two magnetron electrodes are alternatively operated as cathode. However, such a twin electrode arrangement may also use electrodes without magnets, but only plain electrodes, especially planar electrodes.

The frequency by which the electrodes are switched from a cathode to an anode and vice versa may be set in the range of 1 kHz to 1 MHz, especially 10 kHz to 100 kHz and preferably 30 kHz to 50 kHz. However, instead of an AC power supply a DC power supply or pulsed DC may also be used.

By carrying out the inventive method a layer system, also designated as composite foil, comprising a plastic substrate layer, a first barrier layer comprising a metal and a second barrier layer comprising a resin as well as an adhesive inter layer between the first barrier layer and the second barrier layer can be produced. The adhesive layer may comprise only one or several atomic layers of the sputter deposited material like steel, stainless steel, chromium, iron, nickel, vanadium, silicon and oxides as well as alloys thereof. Instead of a continuous adhesive layer it is also possible to only deposit distinct and separate isles of material between the first barrier layer and the second barrier layer.

Such a layer system may be combined with other layers, for example a top layer made of another plastic foil or the like.

### SHORT DESCRIPTION OF THE FIGURES

Further advantages, characteristics and features of the present invention will become apparent from the following detailed description of preferred embodiments with respect to the attached drawings. The drawings show in purely schematic form in
- Fig. 1: a side view of a coating device according to an embodiment of the present invention;
- Fig. 2: a cross section of a band having a layer system according to the present invention; and in
- Fig. 3: a top view onto the first barrier layer and the adhesive layer deposited thereon.

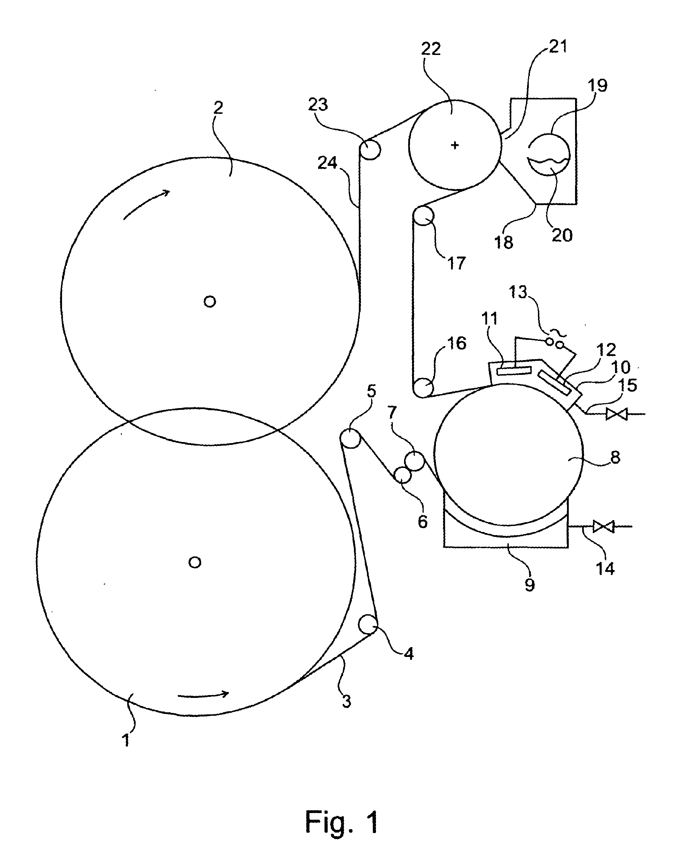

Fig. 1 shows in a purely schematic form a coating device which can be used to produce a layer system according to the present invention as well as for carrying out the inventive method.

Fig. 1 shows a web coating device for coating of a flexible plastic foil in form of a rollable band. Instead of flexible plastic materials it is also conceivable to coat rigid substrates. For such substrates only the transport path has to be amended while the coating stations as well as the treatment station as described below can also be used for rigid substrates.

According to the embodiment shown in fig. 1, the coating device comprises a first winding roll 1 for unwinding the plastic foil 3 to be coated from a coil. The plastic foil 3 or band is guided over several guide rollers 4, 5, 6 and 7 to be received by a first process roll 8. At the process roll 8 a first coating station 9 and a treatment station 10 are arranged.

The first coating station 9 comprises an evaporator by which a metal, like aluminium can be evaporated. In addition, the first coating station 9 comprises a gas supply 14 by which reactive gas, e.g. oxygen, for carrying out reactive evaporation can be supplied to the first coating station 9. During operation of the coating device a metal, for example aluminium, may be evaporated in the first coating station while the band or plastic foil 3 is moved over the first process roll 8 and is therefore passed along the first coating station 9. During passing the first coating station 9 the evaporated metal is deposited onto the plastic foil 3 in order to form a first barrier layer made of aluminium, for example. If during the evaporation process oxygen gas is introduced in the first coating station, aluminium oxide (alumina) Al₂O₃ or AlOₓ may be deposited on the plastic foil as an alternative first barrier layer.

After the first coating station 9 the plastic foil 3 moving along the process roll 8 is passing the treatment station 10 where a sputter deposition process is carried out. For this purpose, the treatment station comprises a so-called "twin mag" electrode arrangement having two electrodes 11 and 12 which are alternatively operated as cathode and anode. Accordingly, the electrodes 11 and 12 are connected to a power supply 13 providing AC voltage with a frequency of 40 kHz. The electrodes 11 and 12 are preferably planar electrodes extending with their length extension across the transport direction of the plastic foil 3. The electrodes 11 and 12 comprise a sputter target which is atomized in order to produce material to be deposited onto the plastic foil 3. The target may be arranged in front of the electrodes 11, 12 or may itself form the electrode. Furthermore, the electrodes 11, 12 may be designed as magnetrons comprising a magnet arrangement (not shown) at the side opposite to the sputter target in order to enhance production of ions in the plasma to be accelerated to the target. Thus, the sputter yield can be improved.

The treatment station also comprises a gas supply 15 which allows supplying reactive gases for reactive sputtering. However, instead of reactive sputtering, for example sputtering of a metal target in the presence of oxygen, the oxides itself, like silicon oxide SiOₓ or similar, may be sputtered directly.

After leaving the treatment station 10, the plastic foil 3 comprising the first barrier layer and one or a view atomic layers of the sputter deposited material is guided over the guide rollers 16 and 17 to a second process roll 22.

At the second process roll 22, which is similar to the first process roll 8 and can also be designated as coating roll, the second coating station 18 is arranged. The second coating station 18 comprises evaporation means for evaporation of a melamine resin 20 which is contained in a heatable pipe 19 the ends of which are closed in order to avoid loss of the melamine resin 20. However, the pipe 19 comprises a slit extending along the length direction of the pipe and across the transport direction of the plastic foil 3, so that after heating of the pipe 19 to a temperature of about 200 to 300 ° C the vapor of the melamine resin can leave the pipe 19. Since the slit in the pipe 19 is directed towards the process roll 22 along which the plastic foil to be coated is transported, the melamine vapor may pass through the opening 21 of the housing of the second coating station 18 and arrive at the pre-coated plastic foil 3 in order to create a second barrier layer comprising melamine resin. After leaving the area of the second coating station 18, the plastic foil 3 is guided by the guide roller 23 to the winding roll 2 which is winding the completely coated plastic foil 24 into a coil.

Since the coating processes at the first coating station 9 and the second coating station 18 as well as the sputter process carried out at the treatment station 10 are processes which are carried out under vacuum conditions, the whole device is incorporated in a vacuum-tight housing which is not shown in fig. 1 for the sake of simplicity.

With the coating device shown in fig. 1 it is possible to carry out the inventive method, since in the first coating station 9 a deposition of a first barrier coating consisting of a metal layer, like aluminium, or a metal oxide layer, like aluminium oxide, is possible.

In the following step at the treatment station 10 a very thin layer of an adhesive layer may be deposited by a sputter technology. Especially, high frequency sputter deposition using two electrodes which are alternatively switched as cathodes and anodes can be performed at frequencies from 1 kHz to 1 MHz, especially 10 kHz to 100 kHz and more preferably 30 kHz to 50 kHz, especially about 40 kHz. As target materials silicon or metals or metal alloys as well as oxides thereof may be used. For example, chromium, vanadium, nickel, iron, steel or stainless steel may be used as a target material. With respect to oxides, Si reactive sputtering can especially be used. Moreover, it is possible to use metal targets or silicon targets under an atmosphere containing oxygen so that reactive sputtering is performed. The sputtering is carried out in a way that only one atomic layer of the material to be deposited or only a few layers, like 2 to 20 or 5 to 15 atomic layers may be deposited onto the first barrier layer which is already present at the substrate. Moreover, it is possible to deposit less material as would be necessary to form a continuous adhesive layer. In this case, instead of a continuous adhesive layer, isles of an adhesive layer or separate conglomerates of deposition material can be arranged on the first barrier layer.

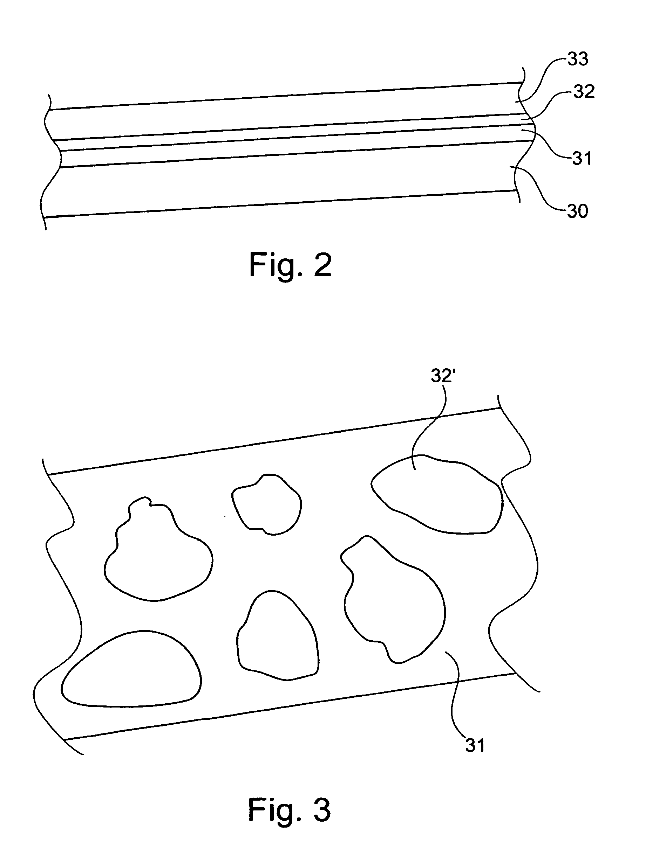

This is schematically shown in figs. 2 and 3.

Fig. 2 shows a cross section through the completely processed plastic foil with the plastic substrate 30, the first barrier layer 31, the adhesive layer 32 and the second barrier layer 33. Accordingly, a layer system shown in fig. 2 may comprise a polyethylene or polyethylene terephthalate as well as polypropylene or biaxial oriented polypropylene substrate 30 onto which an aluminium or alumina layer 31 as the first barrier layer is deposited. On the first barrier layer 31 a continuous adhesive layer 32, as shown in fig. 2, or separate isles of adhesive layer material 32' are provided for.

The adhesive layer 32 or 32' improves the adhesion of the second barrier layer 33 on the first barrier layer wherein the second barrier layer is preferably a melamine resin.

The present invention is therefore especially characterized by the following features, while the scope of protection is solely determined by the attached claims:
1. Coating device for depositing of barrier layers on a plastic substrate comprising a first coating station for depositing a first layer comprising a metal and a second coating station for depositing a second layer comprising a resin, the first coating station comprising evaporation means for evaporation of metals or evaporation means for evaporation of metals and means for reactive deposition,
   wherein
   a treatment station for treating the deposited first layer is arranged between the first and the second coating stations which comprises sputter means for depositing one or several atomic layers or isles of deposition material.
2. Coating device according to feature 1,
   wherein
   the coating device is adapted for continuously moving the substrate to be deposited during deposition processes.
3. Coating device according to feature 1 or 2,
   wherein
   the coating device is a web coating device for coating a flexible plastic foil in form of a rollable band.
4. Coating device according to feature 2 or 3,
   wherein
   drive means for moving the substrate are provided for which are designed to allow a moving speed of the substrate of 0,1 - 20 m/s during passing of the treating station.
5. Coating device according to feature 2 or 3,
   wherein
   drive means for moving the substrate are provided for which are designed to allow a moving speed of the substrate of 3 - 14 m/s during passing of the treating station.
6. Coating device according to feature 2 or 3,
   wherein
   drive means for moving the substrate are provided for which are designed to allow a moving speed of the substrate of 5 to 11 m/s during passing of the treating station.
7. Coating device according to any of the previous features,
   wherein
   the first coating station comprises evaporation means for evaporation of metals.
8. Coating device according to any of the previous features,
   wherein
   the first coating station comprises electron beam evaporation means.
9. Coating device according to any of the previous features,
   wherein
   the first coating station comprises means for performing a hollow cathode arc activated deposition (HAD process).
10. Coating device according to any of the previous features,
   wherein
   the first coating station comprises means for reactive deposition.
11. Coating device according to any of the previous features,
   wherein
   the first coating station comprises gas supply means for supplying reactive gas to the evaporation process.
12. Coating device according to any of the previous features,
   wherein
   the second coating station comprises evaporation means for evaporation of resins.
13. Coating device according to any of the previous features,
   wherein
   the sputter means comprise at least a planar cathode.
14. Coating device according to any of the previous features,
   wherein
   the sputter means comprise at least a magnetron cathode.
15. Coating device according to any of the previous features,
   wherein
   the sputter means comprise at least two electrodes or magnetron electrodes alternatively operated as cathode.
16. Coating device according to any of the previous features,
   wherein
   the sputter means comprise a power supply providing DC voltage or AC voltage to the cathode, the frequency of the AC power being set between 1 kHz and 1 MHz.
17. Coating device according to feature 16,
   wherein
   the power supply is designed such that the frequency may be set between 10 kHz and 100 kHz.
18. Coating device according to feature 16 or 17,
   wherein
   the power supply is designed such that the frequency may be set between 30 kHz and 50 kHz.
19. Coating device according to any of the previous features,
   wherein
   the sputter means comprise a target having at least one of the components of the group comprising steel, stainless steel, chromium, iron, nickel, vanadium, silicon and oxides thereof.
20. Coating device according to any of the previous features,
   wherein
   the sputter means comprise means for reactive sputtering.
21. Coating device according to any of the previous features,
   wherein
   the sputter means comprise gas supply means for supplying reactive gases.
22. Coating device according to any of the previous features,
   wherein
   the first coating station and the treatment station are associated to a first process roll and the second coating station is associated to a second process roll.
23. Method for depositing of barrier layers on a plastic substrate comprising a first coating step for depositing a first layer comprising a metal and a second coating step for depositing a second layer comprising a resin,
   wherein
   a treatment step for treating the deposited first layer is carried out between the first and the second coating steps which comprises sputtering of one or several atomic layer or isles of deposition material onto the substrate.
24. Method according to feature 23,
   wherein
   the substrate is continuously moved during at least one of the first and the second coating step and the treatment step.
25. Method according to feature 23,
   wherein
   the moving speed of the substrate is 0,1 - 20 m/s during passing of the treating station.
26. Method according to feature 23,
   wherein
   the moving speed of the substrate is 3 - 14 m/s during passing of the treating station.
27. Method according to feature 23,
   wherein
   the moving speed of the substrate is 5 - 11 m/s during passing of the treating station.
28. Method according to any of the features 23 to 27,
   wherein
   the substrate is a flexible plastic foil in form of a rollable band.
29. Method according to any one of the features 23 to 28,
   wherein
   the substrate is selected from the group comprising polyethylene PE, polyethylene terephthalate PET, biaxial oriented polypropylene BOPP, polypropylene PP and acetate.
30. Method according to any one of the features 23 to 29,
   wherein
   during the first coating step a metal is evaporated.
31. Method according to any one of the features 23 to 30,
   wherein
   during the first coating step a hollow cathode arc activated deposition (HAD process) or reactive evaporation is carried out.
32. Method according to any one of the features 23 to 31,
   wherein
   during the first coating step A1 or alumina is deposited.
33. Method according to any one of the features 23 to 32,
   wherein
   during the second coating step a resin is deposited.
34. Method according to any one of the features 23 to 33,
   wherein
   during the second coating step a melamine resin is deposited.
35. Method according to any one of the features 23 to 34,
   wherein
   the sputter process is carried out with DC voltage or AC voltage at the cathode, the frequency of the AC power being set between 1 kHz and 1 MHz.
36. Method according to feature 35,
   wherein
   the frequency is set between 10 kHz and 100 kHz.
37. Method according to feature 35,
   wherein
   the frequency is set between 30 kHz and 50 kHz.
38. Method according to any one of the features 23 to 37,
   wherein
   during treatment step at least one of the components of the group comprising steel, stainless steel, chromium, iron, nickel, vanadium, silicon and oxides thereof is deposited.
39. Method according to any one of the features 23 to 38,
   wherein
   during treatment step reactive sputtering is performed.
40. Method according to any one of the features 23 to 39,
   wherein
   the method is carried out under vacuum conditions.
41. Method according to any one of the features 23 to 39,
   wherein
   the method is carried out in a coating device according to any one of the claims 1 to 22.
42. Layer system comprising a plastic substrate layer, a first barrier layer comprising a metal and a second barrier layer comprising a resin,
   wherein
   between the first barrier layer and the second barrier layer an adhesive layer having one or several atomic layers or isles of material is arranged.
43. Layer system according to feature 42,
   wherein
   the adhesive layer comprises at least one of the components of the group comprising steel, stainless steel, chromium, iron, nickel, vanadium, silicon and oxides thereof.
44. Layer system according to feature 42 or 43,
   wherein
   the first barrier layer comprises aluminium or alumina.
45. Layer system according to any one of features 42 to 44,
   wherei
   the second barrier layer comprises a melamine resin.
46. Layer system according to any one of features 42 to 44,
wherein
at least one top layer is provided for.

## Claims

1. Coating device for depositing of barrier layers on a plastic substrate comprising a first coating station (9) for depositing a first layer comprising a metal and a second coating station (18) for depositing a second layer comprising a resin, the first coating station comprising evaporation means for evaporation of metals or evaporation means for evaporation of metals and means for reactive deposition,
**wherein**
a treatment station (10) for treating the deposited first layer is arranged between the first and the second coating stations which comprises sputter means for depositing one or several atomic layers or isles of deposition material.

2. Coating device according to claim 1,
**wherein**
the coating device is a web coating device for coating a flexible plastic foil in form of a rollable band.

3. Coating device according to any of the previous claims,
wherein
the second coating station (18) comprises evaporation means for evaporation of resins.

4. Coating device according to any of the previous claims,
**wherein**
the sputter means comprise at least a planar cathode and/or at least two electrodes (11,12) or magnetron electrodes alternatively operated as cathode.

5. Coating device according to any of the previous claims,
**wherein**
the sputter means comprise a power supply providing DC voltage or AC voltage to the cathode, the frequency of the AC power being set between 1 kHz and 1 MHz.

6. Coating device according to any of the previous claims,
**wherein**
the first coating station (9) and the treatment station (10) are associated to a first process roll and the second coating station (18) is associated to a second process roll.

7. Method for depositing of barrier layers on a plastic substrate (30) comprising a first
coating step for depositing a first layer (31) comprising a metal and a second coating step for depositing a second layer (33) comprising a resin,
**wherein**
a treatment step for treating the deposited first layer is carried out between the first and the second coating steps which comprises sputtering of one or several atomic layer or isles of deposition material onto the substrate.

8. Method according to claim 7,
**wherein**
the substrate (30) is continuously moved during at least one of the first and the second coating step and the treatment step.

9. Method according to any of the claims 7 to 8,
**wherein**
the substrate (30) is a flexible plastic foil in form of a rollable band and is selected from the group comprising polyethylene PE, polyethylene terephthalate PET, biaxial oriented polypropylene BOPP, polypropylene PP and acetate.

10. Method according to any one of the claims 7 to 9,
**wherein**
during the first coating step a hollow cathode arc activated deposition (HAD process) or reactive evaporation is carried out.

11. Method according to any one of the claims 7 to 10,
**wherein**
during the first coating step A1 or alumina is deposited.

12. Method according to any one of the claims 7 to 11,
**wherein**
during the second coating step a resin is deposited.

13. Method according to any one of the claims 7 to 12,
**wherein**
during the second coating step a melamine resin is deposited.

14. Method according to any one of the claims 7 to 13,
**wherein**
during treatment step at least one of the components of the group comprising steel, stainless steel, chromium, iron, nickel, vanadium, silicon and oxides thereof is deposited.

15. Method according to any one of the claims 7 to 14,
**wherein**
during treatment step reactive sputtering is performed.

16. Layer system comprising a plastic substrate layer (30), a first barrier layer (31) comprising a metal and a second barrier layer (33) comprising a resin,
**wherein**
between the first barrier layer and the second barrier layer an adhesive layer (32) having one or several atomic layers or isles of material is arranged.

17. Layer system according to claim 16,
**wherein**
the adhesive layer (32) comprises at least one of the components of the group comprising steel, stainless steel, chromium, iron, nickel, vanadium, silicon and oxides thereof.

18. Layer system according to any one of claims 16 or 17,
**wherein**
at least one top layer is provided for.

## Patentansprüche

1. Beschichtungsvorrichtung zum Aufbringen von Sperrschichten auf ein Kunststoffsubstrat, die eine erste Beschichtungsstation (9) zum Aufbringen einer ersten Schicht, die ein Metall umfasst, und eine zweite Beschichtungsstation (18) zum Aufbringen einer zweiten Schicht, die ein Harz umfasst, aufweist, wobei die erste Beschichtungsstation Verdampfungsmittel zum Verdampfen von Metallen oder Verdampfungsmittel zum Verdampfen von Metallen und Mittel zur Reaktivbeschichtung umfasst,
**bei welcher**
eine Bearbeitungsstation (10) zum Bearbeiten der aufgebrachten ersten Schicht zwischen der ersten und der zweiten Beschichtungsstation angeordnet ist, welche Sputtermittel zum Aufbringen einer oder mehrerer Atomschichten oder Inseln aus Beschichtungsmaterial umfasst.

2. Beschichtungsvorrichtung nach Anspruch 1,
**bei welcher**
die Beschichtungsvorrichtung eine Bandbeschichtungsvorrichtung zum Beschichten einer flexiblen Kunststofffolie in Form eines aufrollbaren Bandes ist.

3. Beschichtungsvorrichtung nach einem der vorhergehenden Ansprüche,
**bei welcher**
die zweite Beschichtungsstation (18) Verdampfungsmittel zum Verdampfen von Harz umfasst.

4. Beschichtungsvorrichtung nach einem der vorhergehenden Ansprüche,
**bei welcher**
die Sputtermittel mindestens eine planare Kathode und/oder mindestens zwei Elektroden (11,12) oder Magnetronelektroden umfassen, die abwechselnd als Kathode betrieben werden.

5. Beschichtungsvorrichtung nach einem der vorhergehenden Ansprüche,
**bei welcher**
die Sputtermittel eine Stromversorgung umfassen, die Wechsel- oder Gleichstrom für die Kathode bereitstellt, wobei die Frequenz des Wechselstroms zwischen 1 kHz und 1 MHz eingestellt ist.

6. Beschichtungsvorrichtung nach einem der vorhergehenden Ansprüche,
**bei welcher**
die erste Beschichtungsstation (9) und die Bearbeitungsstation (10) einer ersten Prozessrolle zugeordnet sind und die zweite Beschichtungsstation (18) einer zweiten Prozessrolle zugeordnet ist.

7. Verfahren zum Aufbringen einer Sperrschicht auf ein Kunststoffsubstrat (30), das einen ersten Beschichtungsschritt zum Aufbringen einer ersten Schicht (31), die ein Metall umfasst, und einen zweiten Beschichtungsschritt zum Aufbringen einer zweiten Schicht (33), die ein Harz umfasst, beinhaltet,
**bei welchem**
ein Bearbeitungsschritt zur Bearbeitung der aufgebrachten ersten Schicht, der das Sputtern einer oder mehrerer Atomschichten oder Inseln aus Beschichtungsmaterial auf das Substrat umfasst, zwischen dem ersten und dem zweiten Beschichtungsschritt ausgeführt wird.

8. Verfahren nach Anspruch 7,
**bei welchem**
das Substrat (30) kontinuierlich während mindestens einem von den ersten und zweiten Beschichtungsschritten und dem Bearbeitungsschritt bewegt wird.

9. Verfahren nach einem der Ansprüche 7 oder 8,
**bei welchem**
das Substrat (30) eine flexible Kuriststofffolle in Form eines aufrollbaren Bandes ist und aus der Gruppe ausgewählt ist, die Polyethylen PE, Polyethylenterephthalat PET, biaxial orientiertes Polypropylen BOPP, Polypropylen PP und Acetat umfasst.

10. Verfahren nach einem der Ansprüche 7 bis 9,
**bei welchem**
während des ersten Beschichtungsschritts eine Hohlkathoden-Lichtbogen aktivierte Aufbringung (HAD Prozess (hollow cathode arc activated deposition)) oder eine reaktive Verdampfung ausgeführt wird.

11. Verfahren nach einem der Ansprüche 7 bis 10,
**bei welchem**
während des ersten Beschichtungsschritts A1 oder Aluminiumoxid aufgebracht wird.

12. Verfahren nach einem der Ansprüche 7 bis 11,
**bei welchem**
während der zweiten Beschichtungsschritts ein Harz aufgebracht wird.

13. Verfahren nach einem der Ansprüche 7 bis 12,
**bei welchem**
während des zweiten Beschichtungsschritts ein Melaminharz aufgebracht wird.

14. Verfahren nach einem der Ansprüche 7 bis 13,
**bei welchem**
während des Bearbeitungsschritts mindestens eine Komponente aus der Gruppe aufgebracht wird, die Stahl, rostfreien Stahl, Chrom, Eisen, Nickel, Vanadium, Silicon und Oxide davon umfasst.

15. Verfahren nach einem der Ansprüche 7 bis 14,
bei welchem
während des Bearbeitungsschritts reaktives Sputtern ausgeführt wird.

16. Schichtensystem, das eine Kunststoffsubstratsschicht (30), eine erste Sperrschicht (31), die ein Metall umfasst, und eine zweite Sperrschicht (33), die ein Harz umfasst, aufweist,
**bei welcher**
zwischen der ersten Sperrschicht und der zweite Sperrschicht eine Haftungsschicht (32) angeordnet ist, die eine oder mehrere Atomschichten oder Materialinseln umfasst.

17. Schichtensystem nach Anspruch 16,
**bei welcher**
die Haftungsschicht (32) mindestens eine Komponente aus der Gruppe aufweist, die Stahl, rostfreien Stahl, Chrom, Eisen, Nickel, Vanadium, Silizium und Oxide davon umfasst.

18. Schichtensystem nach einem der Ansprüche 16 oder 17,
**bei welcher**
mindestens eine Oberflächenschicht bereitgestellt ist.

## Revendications

1. Dispositif de revêtement pour déposer des couches barrières sur un substrat plastique comprenant un premier poste de revêtement (9) pour déposer une première couche comprenant un métal et un second poste de revêtement (18) pour déposer une seconde couche comprenant une résine, le premier poste de revêtement comprenant des moyens d'évaporation pour l'évaporation de métaux ou des moyens d'évaporation pour l'évaporation de métaux et des moyens pour le dépôt réactif dans lequel un poste de traitement (10) pour traiter la première couche déposée est arrangé entre le premier poste de traitement et le second poste de traitement qui comprend des moyens de pulvérisation cathodique pour déposer une ou plusieurs couches atomiques ou des îlots de matériau de dépôt.

2. Dispositif de revêtement selon la revendication 1 dans lequel le dispositif de revêtement est un dispositif de revêtement de bande continue pour revêtir une feuille plastique flexible en forme de bande enroulable

3. Dispositif de revêtement selon l'une quelconque des revendications précédentes dans lequel le second poste de revêtement (18) comprend des moyens d'évaporation pour l'évaporation de résines.

4. Dispositif de revêtement selon l'une quelconque des revendications précédentes dans lequel les moyens de pulvérisation cathodique comprennent au moins une cathode planaire et/ou au moins deux électrodes (11, 12) ou magnétrons fonctionnant de manière alternative comme cathode.

5. Dispositif de revêtement selon l'une quelconque des revendications précédentes dans lequel les moyens de pulvérisation cathodique comprennent une alimentation en courant qui fournit une tension continue ou une tension alternative à la cathode, la fréquence du courant alternatif étant fixée entre 1 kHz et 1 MHz.

6. Dispositif de revêtement selon l'une quelconque des revendications précédentes dans lequel le premier poste de revêtement (9) et le poste de traitement (10) sont associés à un premier rouleau de traitement et le second poste de revêtement (19) est associé à un second rouleau de traitement.

7. Procédé pour déposer des couches barrières sur un substrat plastique (30) comprenant une première étape de revêtement pour déposer une première couche (31) comprenant un métal et une seconde étape de revêtement pour déposer une seconde couche (33) comprenant une résine dans lequel une étape de traitement pour traiter la première couche déposée est effectuée entre la première et la seconde étape de revêtement qui comprend la pulvérisation cathodique d'une ou de plusieurs couches atomiques ou îlots de matériau de dépôt sur le substrat.

8. Procédé selon la revendication 7 dans lequel le substrat (30) est continuellement déplacé pendant au moins l'une des étapes de revêtement, la première et la seconde de revêtement et l'étape de traitement.

9. Procédé selon l'une quelconque des revendications 7 à 8 dans lequel le substrat (30) est une feuille plastique flexible en forme de bande enroulable et est sélectionné dans le groupe comprenant le polyéthylène PE, le polyéthylène téréphtalate PET, le polypropylène bi-orienté BOPP, le polypropylène PP et l'acétate.

10. Procédé selon l'une quelconque des revendications 7 à 9 dans lequel un dépôt activé par arc à cathode creuse (processus HAD) ou une évaporation réactive est effectuée pendant la première étape de revêtement.

11. Procédé selon l'une quelconque des revendications 7 à 10 dans lequel de l'Al ou oxyde d'aluminium est déposé pendant la première étape de revêtement.

12. Procédé selon l'une quelconque des revendications 7 à 11 dans lequel une résine est déposée.

13. Procédé selon l'une quelconque des revendications 7 à 12 dans lequel une résine de mélamine est déposée pendant la seconde étape de revêtement.

14. Procédé selon l'une quelconque des revendications 7 à 13 dans lequel au moins l'un des composants du groupe comprenant l'acier, l'acier inoxydable, le chrome, le fer, le nickel, le vanadium, le silicium et des oxydes de ceux-ci est déposé pendant l'étape de traitement.

15. Procédé selon l'une quelconque des revendications 7 à 14 dans lequel une pulvérisation cathodique réactive est effectuée pendant l'étape de traitement.

16. Système de couche comprenant une couche de substrat plastique (30), une première couche barrière (31) comprenant un métal et une seconde couche barrière (33) comprenant une résine dans lequel une couche adhésive (32) ayant une ou plusieurs couches atomiques ou îlots de matériau est arrangée entre la première couche barrière et la seconde couche barrière.

17. Système de couche selon la revendication 16 dans lequel la couche adhésive (32) comprend au moins l'un des composants du groupe comprenant l'acier, l'acier inoxydable, le chrome, le fer, le nickel, le vanadium, le silicium et des oxydes de ceux-ci.

18. Système de couche selon l'une quelconque des revendications 16 ou 17 dans lequel au moins une couche de dessus est prévue.
